# EUROPEAN PATENT SPECIFICATION

(11) **EP 1 081 573 B1**
(45) Date of publication and mention of the grant of the patent: **09.04.2003**
(21) Application number: 99830542.9
(22) Date of filing: 31.08.1999
(51) Int. Cl.: G05F 3/24, H03F 1/22

(54) **High-precision biasing circuit for a cascoded CMOS stage, particularly for low noise amplifiers**
Hochgenaue Vorspannungsschaltung für eine CMOS Kaskodenstufe, insbesondere für rauscharme Verstärker
Circuit de polarisation de haute précision pour un étage cascode à CMOS, en particulier pour amplificateurs à faible bruit

(43) Date of publication of application: 07.03.2001
(73) Proprietor: STMicroelectronics S.r.l., 20041 Agrate Brianza (Milano) (IT)
(72) Inventor: Gramegna, Giuseppe, 95100 Catania (IT); D'Aquila, Alessandro, 90146 Palermo (IT); Merletta, B. Marco, 95025 ACI S. Antonio (CT) (IT)
(74) Representative: Botti, Mario

(56) References cited:
- US-A- 4 528 520
- US-A- 5 563 553
- US-A- 5 717 360
- US-A- 5 748 040
- US-A- 5 838 191

## Description

### Background of the invention

The present invention relates to a high-precision biasing circuit for a CMOS cascoded stage with inductive load and degeneration, said cascoded stage including at least a couple of MOS transistors serially connected between a first voltage reference and a second voltage reference.

The invention relates also to a method for biasing a CMOS cascoded stage.

The invention has been developed for a Low Noise Amplifier (LNA) having very large linearity, high gain and ultra low noise (∼ Pin=-4dBm, Gain= 14dB, 50Ω matching at the input and at the output, noise figure NF < I,5 dB).

The on-chip integration of inductors in CMOS technology is making feasible complete transceivers into a single chip. Moreover, cascoded topologies with inductive load and degeneration have been recently integrated in Low Noise Amplifiers (LNA) and Mixers.

Figure 1a shows a schematic example of a single ended Low Noise Amplifier, while Figure 1b is a schematic example of a differential Low Noise Amplifier. The amplifier includes a CMOS cascoded final stage comprising a first input MOS transistor M1 and a second common gate MOS transistor M2.

There is a competitive advantage in using CMOS technology with inductive and noiseless degeneration since the linearity is improved while the inductive load allows the output node to swing over the supply voltage, ensuring a large dynamic range.

Figure 2a shows a schematic example of an application where two transistors are in a cascoded configuration to achieve a single ended Mixer, while Figure 2b is a schematic example of a double cascoded transistors configuration to achieve a differential Mixer.

Wide dynamic range, large linearity and good noise performance can be achieved at the expenses of high current levels.

Additionally, the channel length L of the MOS transistor must be kept minimum and the width W must be kept at small-medium values.

The resulting high current density forced through minimum length transistors make them extremely sensitive on the co-called "early" effect. As the load and the degeneration are inductive, the voltage drop Vds(M1) between the drain and source terminals of the first MOS transistor M1 plus the voltage drop Vds(M2) between the drain and source terminals of the second MOS transistor M2 is equal to the supply voltage Vdd.

To ensure a proper control on gain, noise figure and input impedance, the cascoded stage must be biased taking into account the early effect. Therefore, the CMOS stage must be provided of a noiseless, high precision biasing circuit. This is particularly critical because of the following reasons:
- the series of the first input transistor M1 and the second common gate transistor M2 receives all the DC supply voltage;
- both transistors M1 and M2 are heavily affected by the early effect;
- the circuit performances, i.e. its voltage gain, input impedance and NF, depend heavily upon the biasing current.

The problem to bias such LNA circuits can be generalised in the problem to bias a CMOS cascoded stage comprising a couple of transistors connected in series and receiving the full DC supply voltage. The gate of second transistor M2 is connected to the supply voltage reference Vdd or to a proper DC potential according to the particular application.

### Prior art

A variety of biasing circuits has been proposed by the known art for solid state amplifiers. Many of these known biasing circuits may be adopted to bias the selective LNA.

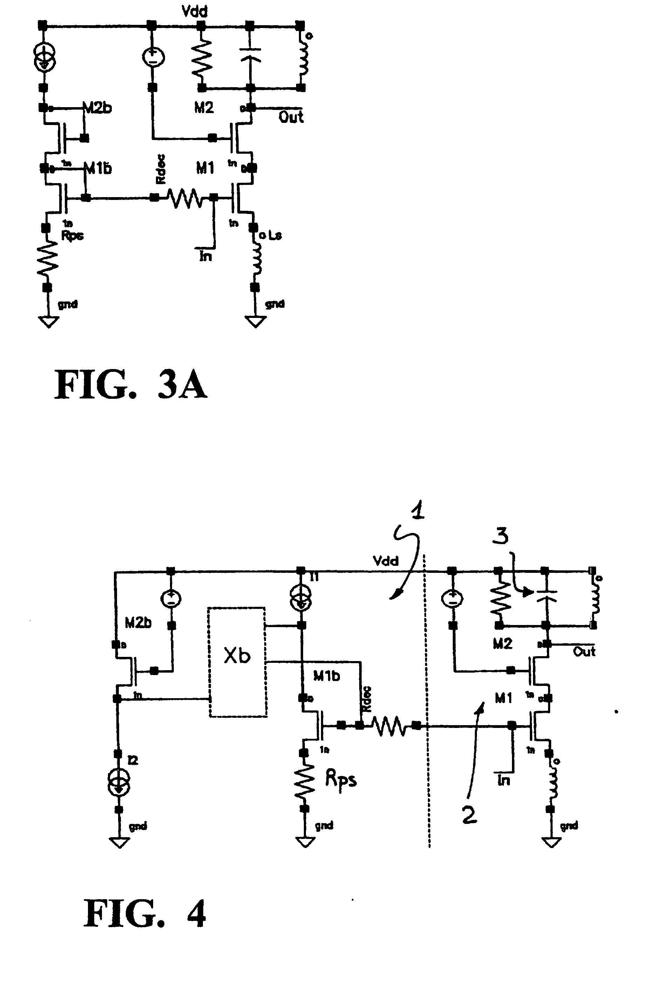

One of the most used biasing circuit is shown in Figure 3a and is a circuit derived by a classic cascoded current mirror. The resistance Rps represents a DC resistance associated to a non-ideal inductor Ls.

This solution has a drawback due to the fact that the threshold voltage of the transistors M1 and M2 is tracked, while the early effect of the same transistors M1 and M2 (plus the body effect just of transistor M2) is not tracked.

Others prior art solutions fails for the same reason: the interposition of a current generator connected in series with the transistors M1b and M2b may compensate the early effect of one of the transistors M1 or M2, but not both, since Vds(M1b) + Vds(M2b) < Vds(M1) + Vds(M2) =Vdd.

For instance, a prior art solution is disclosed in the US patent No. 5,838,191 relating to a bias circuit for switched capacitor applications. This solution teaches how to maintain a constant settling time of CMOS operational amplifies by forcing substantially constant bias currents to both transistors.

The object of the present invention is to provide a new high-precision biasing circuit for a cascoded CMOS stage, particularly for low noise amplifiers.

A further object of the present invention is to provide a biasing circuit having no sensing points inside.

A further object of the invention is to provide a biasing circuit for a cascoded CMOS final output stage driving an inductive load with a proper control gain and noise figure.

Moreover, the aim of the invention is that of providing the desired biasing conditions for a low noise audio amplifier for wireless communications.

### Summary of the invention

The solution idea on which the invention is based provides a "splitting biasing technique" and the problem to bias the cascoded stage is splitted into sub-problems as disclosed hereinafter:
- the inventive bias circuit comprises two replicas of the transistors M1 and M2 included in the cascoded stage and the desired biasing conditions are forced to one replicant transistor;
- an electrical information relevant for the biasing conditions are read from said replicant transistor and the desired bias conditions are forced to the other replicant transistor using the electrical information previously achieved.

According to this solution idea the invention relates to a high-precision biasing circuit defined by the enclosed claim 1.

The invention relates also to a method for biasing a CMOS cascoded stage for a low noise amplifier.

The features and the advantages of the biasing circuit and method according to the invention, will become clear from the following description of a preferred embodiment given as non-limiting example with reference to the attached drawings.

### Brief description of the drawings

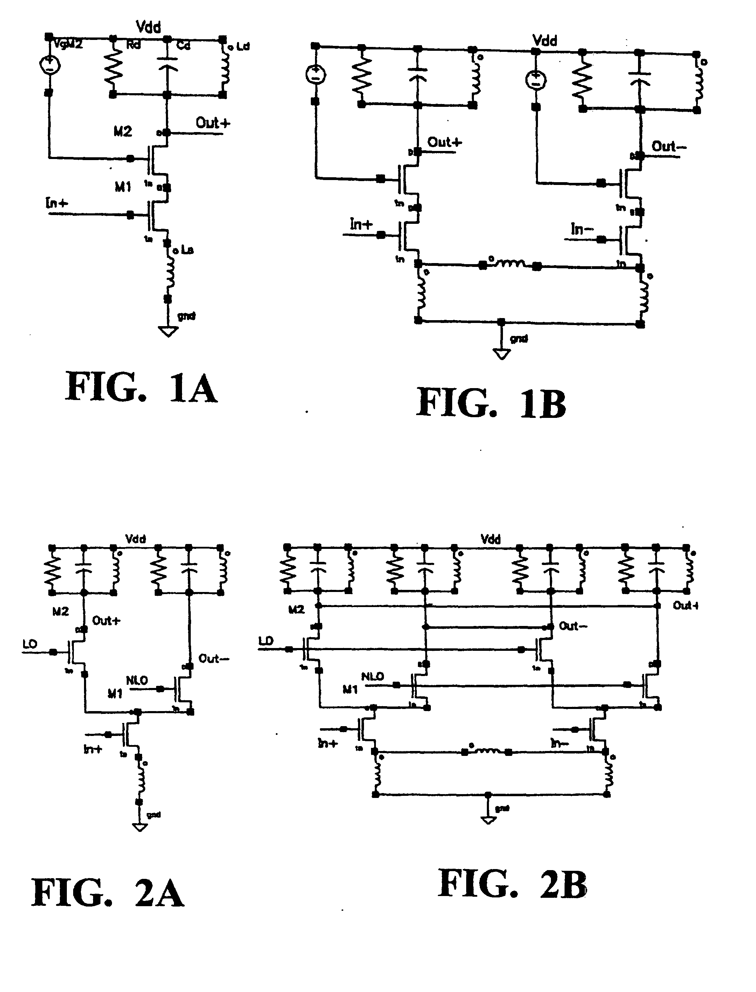

Figure 1a shows a schematic view of a known single ended Low Noise Amplifier;
Figure 1b shows a schematic view of a known differential Low Noise Amplifier;
Figure 2a shows a schematic view of a known single ended Mixer;
Figure 2b shows a schematic view of a known differential Mixer;
Figure 3a shows a schematic view of a cascoded current mirror circuit for biasing a CMOS cascoded stage according to the prior art;
Figure 4 shows a schematic view of a biasing circuit according to the present invention;

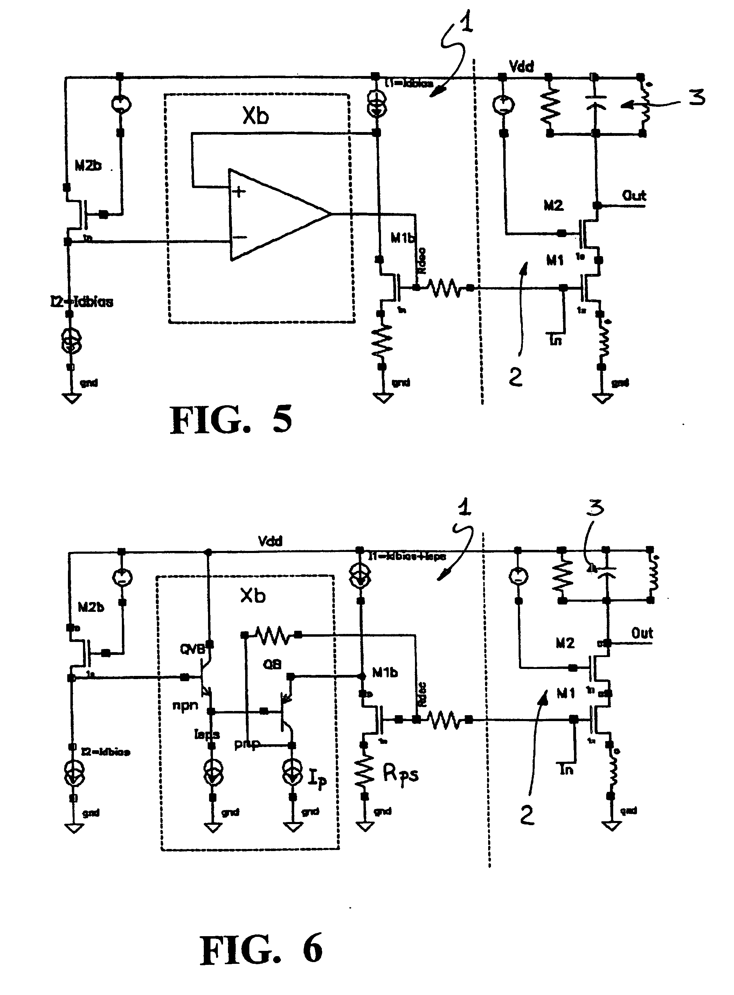

Figure 5 shows a first schematic embodiment of the biasing circuit of Figure 4;
Figure 6 shows a second schematic embodiment of the biasing circuit of Figure 4.

### Detailed description

With reference to the drawing figures, with 1 is globally indicated a high-precision biasing circuit realised according to the present invention for a CMOS cascoded stage 2 with inductive load and degeneration.

The biasing circuit 1 may be associated to a transistor stage including at least a couple of transistor and the following description is given just by way of non-limiting example of an implementation concerning a CMOS cascoded stage for an audio low noise amplifier for wireless communications, which is not shown being of a conventional type.

The stage 2 includes a series of a first input MOS transistor M1 and a second common gate MOS transistor M2.

The transistors M1, M2 are serially connected between a first supply voltage reference Vdd and a second voltage reference GND.

The gate of the first transistor M1 receives an input signal In.

The gate of the second transistor M2 is coupled to the first voltage reference Vdd via a voltage generator.

An RLC circuit portion 3 is interposed between the first voltage reference Vdd and the drain terminal of the second transistor M2.

An inductive load L is connected between the source terminal of the first transistor M1 and the second voltage reference GND.

According to the present invention, the biasing circuit 1 includes a first replica transistor M1b that is matched to the first input transistor M1 of the stage 2.

This first replica transistor M1b is coupled to the first voltage reference Vdd via a current generator I1 and to the second voltage reference GND through a resistor Rps. The gate of this replica transistor M1b is connected to the gate of the first input transistor M1 through a resistor Rdec.

The biasing circuit 1 includes also a second replica transistor M2b that is connected to the first voltage reference Vdd and coupled to the second voltage reference GND through a current generator I2.

The gate of the second replica transistor M2b is coupled to the first voltage reference Vdd through a voltage generator.

Advantageously, according to the invention, a further circuit component or block Xb is provided connecting the first and the second replica transistors M1b and M2b.

More specifically, the component Xb includes means for detecting the voltage value on a terminal, for instance the source terminal, of the second replica transistor M2b and to force a voltage value on the gate terminal of the first replica transistor M1b. A further input of the circuit block Xb is connected to a conduction terminal, for instance the drain terminal, of the first replica transistor M1b.

Let's now consider the inventive biasing method according to the present invention.

A desired bias conditions are forced to the second replica transistor M2b. Those desired bias conditions are forced to M2b by means of the current generator I2.

An electric information or signal, which is relevant for the biasing conditions of the first replica transistor M1b, is detected. For instance, the voltage drop Vs(M2b) on the source terminal of the second replica transistor M2b is read and processed by the circuit block Xb.

Then, a desired bias condition is forced to the first replica transistor M1b using the electric information or signal previously detected. More specifically, the current generator I1 forces a basic bias condition on the first replica transistor M1b and a further driving signal is applied by the circuit block Xb on the gate terminal of the first replica transistor M1b. The voltage value applied to such a gate terminal depends on the voltage value Vs(M2b) on the source terminal of the second replica transistor M2b.

The competitive advantage compared to conventional bias technique is that the biasing circuit 1 doesn't affect the performances of the whole circuit structure since there are no 'sensing' point inside the biasing circuit.

The inventive concept may be generalised to whatever circuit composed by N transistors, although we don't provide here any other example for circuits different that the CMOS cascoded stages.

The invention provides substantially a splitting biasing technique since the current generators I2, I1 and the circuit block Xb apply the desired bias conditions.

A first preferred embodiment of the circuit block Xb is shown schematically in Figure 5.

The circuit block Xb may be implemented by a voltage amplifier. The current generators I2 and I1 force the desired bias current to the respective replica transistors M2b and M1b. The amplifier block Xb reads out the voltage value Vs(M2b) on the second replica transistor source terminal and forces to the gate of first replica transistor M1b the proper gate voltage Vg(M1b) which takes also into account the imposed drain voltage Vd(M1b) and the bias current I1.

Since a possible lack of precision of this first circuit embodiment may be due to the finite open loop gain of the voltage amplifier, a second alternative embodiment is disclosed hereinafter with reference to Figure 6.

In this second embodiment, that has a specific advantage of saving current, the circuit block Xb is implemented by a portion of a folded cascoded amplifier closed in a shunt feedback.

More particularly, a bipolar transistor QVB is connected to the first voltage reference Vdd and coupled to the second voltage reference GND through a current generator Ieps. The driving and base terminal of this bipolar transistor QVB is directly connected to the source terminal of the second replica transistor M2b. A further bipolar transistor QB is serially connected to a current generator Ip between the drain terminal of the first replica transistor and the second voltage reference GND.

The base of this further transistor QB is connected to the emitter of the first bipolar transistor QVB while the collector terminal is coupled to the gate terminal of the first replica transistor M1b via a resistor.

The first bipolar transistor QVB detects the voltage value Vs(M2b) on the source terminal of the second replica transistor M2b and uses this value to force biasing of the first replica transistor M1b. More precisely, if the bipolar transistors QB and QVB experience the same current densities (for sake of simplicity in the circuit depicted in Figure 6 the current values and the transistors areas are equal) the result is that Vd(M1b) = Vs(M2b). Moreover, the dashed line circuit block Xb, the first replica transistor M1b the current generator I1 and the resistor Rps represent a folded cascoded voltage amplifier closed in shunt-feedback, while the bipolar transistor QVB and the current generator Ieps represent a voltage buffer.

In particular the first bipolar transistor QVB acts at the same time as voltage translator and as common base of the folded cascoded amplifier. It results that the first replica transistor M1b is able of auto-biasing to a proper gate voltage which takes into account the imposed voltage value Vd(M1b) and the bias current I1. The achieved gate voltage Vg(M1b) is forced to the gate of the first input transistor M1, thus the first replica transistor M1b experiences at its terminals the same voltage values experienced by first input transistor M1. The aspect ratios of M1b and M2b are related to the aspect ratio of the transistors M1 and M2 of the cascoded stage 2.

The aspect ratio is reported by the following relation: (W/L)1,2 =k*(W/L)b1,2.

The result is that the second replica transistor M2b and the first replica transistor M1b experience exactly the same bias conditions experienced by transistor M2 and M1 of the stage 2 (early and body effects included). Therefore, a LNA including such a CMOS stage 2 would be biased to a DC current Ids = k*Idbias which is insensitive to whatever threshold variation, early and body effect of the CMOS stage transistors M1 and M2.

For completeness of disclosure, it might be noted that the current value Idbias is obtained from a ratio: Vbandgap/Rbias, where Rbias is a temperature-compensated resistance and Vbandgap is a temperature stable voltage generated by a bandgap regulator.

The circuit and method according to the invention provides a high-precision biasing circuit with minimum noise and tracking the early effect of a CMOS cascoded stage.

## Claims

1. A high-precision biasing circuit (1) for a CMOS cascoded stage (2) with inductive load and degeneration, said cascoded stage (2) including at least a couple of MOS transistors (M1, M2) serially connected between a first voltage reference (Vdd) and a second voltage reference (GND), wherein said biasing circuit (1) includes at least a first MOS replica transistor (M1b) and a second MOS replica transistor (M2b); biasing means (I1, I2) for biasing said first and second replica transistors (M1b, M2b); **characterised by** comprising a circuit block (Xb) including means for detecting the voltage value (Vs) on a terminal of the second replica transistor (M2b) and to force a voltage value (Vg) on the gate terminal of the first replica transistor (M1b) according to said detected voltage value (Vs); said circuit block (Xb) including a circuit portion forming a folded cascoded voltage amplifier closed in a shunt feedback with said first replica transistor (M1b) and a corresponding biasing means (I1, Rps)..

2. A high-precision biasing circuit according to claim 1, wherein a further input of said circuit block (Xb) is connected to a conduction terminal of the first replica transistor (M1b).

3. A high-precision biasing circuit according to claim 1, wherein said biasing means for biasing said first and second replica transistors (M1b, M2b) correspond to current generators (I1, I2).

4. A high-precision biasing circuit according to claim 1, wherein said circuit block (Xb) is a voltage amplifier having a first input connected to terminal of the second replica transistor (M2b) and output connected to said gate terminal of the first replica transistor (M1b) and a further input connected to a conduction terminal of the first replica transistor (M1b).

5. A high-precision biasing circuit according to claim 1, wherein said portion includes bipolar transistors (QVB, QB).

6. A high-precision biasing circuit according to claim 1, wherein the aspect ratio of the first and second replica transistors (M1b, M2b) are related to the aspect ratio of the couple of MOS transistors (M1, M2) included in the CMOS cascoded stage (2).

7. A low noise audio amplifier for wireless communications including a CMOS cascoded stage (2) and a high-precision biasing circuit according to claim 1 for said cascoded stage (2).

8. Method for biasing a CMOS cascoded stage (2) for a low noise amplifier, said cascoded stage including at least a couple of MOS transistors (M1, M2) serially connected between a first voltage reference (Vdd) and a second voltage reference (GND) and a circuit block (Xb) according to claim 1, further comprising:
- providing a first and a second replica transistor (M1b, M2b) of the couple of transistors (M1, M2) of the cascoded stage;
- biasing said replica transistors (M1b, M2b);
- detecting an electric information or signal on one terminal of the second replica transistor (M2b) and forcing a predetermined bias condition on the gate terminal of the other replica transistor (M1b) using the electric information previously achieved.

## Patentansprüche

1. Hochgenaue Vorspannungsschaltung (1) für eine CMOS-Kaskodenstufe (2) mit induktiver Last und Gegenkopplung, wobei die Kaskodenstufe (2) mindestens ein Paar MOS-Transistoren (M1, M2) aufweist, die zwischen einer ersten Vergleichsspannung (Vdd) und einer zweiten Vergleichsspannung (GND) in Reihe geschaltet sind, wobei die Vorspannungsschaltung (1) aufweist: mindestens einen ersten MOS-Replica-Transistor (M1b) und einen zweiten MOS-Replica-Transistor (M2b); Vorspannungsmittel (I1, I2) zum Vorspannen des ersten und zweiten Replica-Transistors (M1b, M2b); **dadurch gekennzeichnet, dass** er einen Schaltungsblock (Xb) umfasst, der Mittel zum Detektieren des Spannungswerts (Vs) an einem Anschluss des zweiten Replica-Transistors (M2b) aufweist und um einen Spannungswert (Vg) am Gate-Anschluss des ersten Replica-Transistors (M1b) gemäß dem detektierten Spannungswert (Vs) zu erzwingen; wobei der Schaltungsblock (Xb) einen Schaltungsbereich aufweist, der einen gefalteten Kaskodenspannungsverstärker bildet, der mit dem ersten Replica-Transistor (M1b) und einem entsprechenden Vorspannungsmittel (I1, Rps) zu einer parallelen Rückkopplung geschlossen ist.

2. Hochgenaue Vorspannungsschaltung nach Anspruch 1, wobei ein weiterer Eingang des Schaltungsblocks (Xb) mit einem Leitungsanschluss des ersten Replica-Transistors (M1b) verbunden ist.

3. Hochgenaue Vorspannungsschaltung nach Anspruch 1, wobei das Vorspannungsmittel zum Vorspannen des ersten und zweiten Replica-Transistors (M1b, M2b) den Stromgeneratoren (I1, I2) entspricht.

4. Hochgenaue Vorspannungsschaltung nach Anspruch 1, wobei der Schaltungsblock (Xb) ein Spannungsverstärker ist, der einen ersten Eingang, der mit dem Anschluss des zweiten Replica-Transistors (M2b) verbunden ist, und einen Ausgang, der mit dem Gate-Anschluss des ersten Replica-Transistors (M1b) verbunden ist, und einen weiteren Eingang, der mit einem Leitungsanschluss des ersten Replica-Transistors (M1b) verbunden ist, aufweist.

5. Hochgenaue Vorspannungsschaltung nach Anspruch 1, wobei der Bereich bipolare Transistoren (QVB, QB) aufweist.

6. Hochgenaue Vorspannungsschaltung nach Anspruch 1, wobei das Größenverhältnis des ersten und zweiten Replica-Transistors (M1b, M2b) mit dem Größenverhältnis des Paars MOS-Transistoren (M1, M2), die in der CMOS-Kaskodenstufe (2) enthalten sind, im Zusammenhang steht.

7. Rauscharmer Tonfrequenzverstärker zur drahtlosen Kommunikation, der eine CMOS-Kaskodenstufe (2) und eine hochgenaue Vorspannungsschaltung nach Anspruch 1 für die Kaskodenstufe (2) aufweist.

8. Verfahren zum Vorspannen einer CMOS-Kaskodenstufe (2) für einen rauscharmen Verstärker, wobei die Kaskodenstufe mindestens ein Paar MOS-Transistoren (M1, M2) aufweist, die zwischen einer ersten Vergleichsspannung (Vdd) und einer zweiten Vergleichsspannung (GND) und einem Schaltungsblock (Xb) nach Anspruch 1 in Reihe geschaltet sind, weiter umfassend:
- Vorsehen eines ersten und zweiten Replica-Transistors (M1b, M2b) des Paars Transistoren (M1, M2) der Kaskodenstufe;
- Vorspannen der Replica-Transistoren (M1b, M2b);
- Detektieren einer elektrischen Information oder eines elektrischen Signals an einem Anschluss des zweiten Replica-Transistors (M2b) und Erzwingen eines vorbestimmten Vorspannungszustands am Gate-Anschluss des anderen Replica-Transistors (M1b) unter Verwendung der zuvor erreichten elektrischen Information.

## Revendications

1. Circuit de polarisation de haute précision (1) pour un étage cascode CMOS (2) avec une charge inductive et une contre-réaction, ledit étage cascode (2) incluant au moins un couple de transistors MOS (M1, M2) connectés en série entre une première tension de référence (Vdd) et une seconde tension de référence (GND), dans lequel ledit circuit de polarisation (1) inclut au moins un transistor de mesure directe MOS (M1b) et un second transistor de mesure directe MOS (M2b) ; des moyens de polarisation (I1, I2) permettant de polariser lesdits premier et second transistors de mesure directe (M1b, M2b), **caractérisé par** un bloc de circuit (Xb) incluant des moyens permettant de détecter la valeur de tension (Vs) sur une borne du second transistor de mesure directe (M2b) et de forcer une valeur de tension (Vg) sur la borne de grille du transistor de mesure directe (M1b) selon ladite valeur de tension détectée (Vs) ; ledit bloc de circuit (Xb) inclut une partie de circuit formant ainsi un amplificateur de tension cascode replié enfermé dans une contre-réaction parallèle avec ledit transistor de mesure directe (M1b) et les moyens de polarisation correspondants (I1, Rps).

2. Circuit de polarisation de haute précision selon la revendication 1, dans lequel une autre entrée dudit bloc de circuits (Xb) est connectée à une borne conductrice du transistor de mesure directe (M1b).

3. Circuit de polarisation de haute précision selon la revendication 1, dans lequel lesdits moyens de polarisation permettant de polariser lesdits premier et second transistors de mesure directe (M1b, M2b) correspondent aux générateurs de courant (I1, I2).

4. Circuit de polarisation de haute précision selon la revendication 1, dans lequel ledit bloc de circuit (Xb) est un amplificateur de tension ayant une première entrée connectée à une borne du second transistor de mesure directe (M2b) et une sortie connectée à ladite borne de grille du transistor de mesure directe (M1b) et une autre entrée connectée à une borne conductrice du transistor de mesure directe (M1b).

5. Circuit de polarisation de haute précision selon la revendication 1, dans lequel ladite partie inclut des transistors bipolaires (QVB, QB).

6. Circuit de polarisation de haute précision selon la revendication 1, dans lequel le rapport largeur/longeur des premier et second transistors de mesure directe (M1b, M2b) est en relation avec le rapport largeur/longueur du couple de transistors MOS (M1, M2) inclus dans l'étage cascode CMOS (2).

7. Amplificateur audio à faible bruit destiné à des communications sans fil incluant un étage cascode CMOS (2) et un circuit de polarisation de haute précision selon la revendication 1 destiné à l'étage cascode précité (2).

8. Procédé permettant de polariser un étage cascode CMOS (2) destiné à un amplificateur à faible bruit, ledit étage cascode incluant au moins un couple de transistors MOS (M1, M2) connectés en série entre une première tension de référence (Vdd) et une seconde tension de référence (GND) et un bloc de circuit (Xb) selon la revendication 1, comprenant en outre les étapes consistant à :
- fournir un premier et un second transistors de mesure directe (M1b, M2b) du couple de transistors (M1, M2) de l'étage cascode ;
- polariser lesdits transistors de mesure directe (Mlb, M2b) ;
- détecter des informations électriques ou un signal sur une borne du second transistor de mesure directe (M2b) et forcer un état de polarisation prédéterminé sur la borne de grille de l'autre transistor de mesure directe (M1b) en utilisant les informations électriques obtenues précédemment.
